## Europäisches Patentamt
## European Patent Office
## Office européen des brevets

(19)

(11) Veröffentlichungsnummer: **0 003 232**
**A1**

(12)

# EUROPÄISCHE PATENTANMELDUNG

(21) Anmeldenummer: **78101773.6**

(22) Anmeldetag: **19.12.78**

(51) Int. Cl.²: **G 06 F 11/10**
**H 04 L 1/10**

(30) Priorität: **30.12.77 DE 2758952**

(43) Veröffentlichungstag der Anmeldung:
**08.08.79 Patentblatt 79/16**

(84) Benannte Vertragsstaaten:
**CH GB IT NL SE**

(71) Anmelder: **SIEMENS AKTIENGESELLSCHAFT Berlin und München**
**Postfach 261**
**D-8000 München 22(DE)**

(72) Erfinder: **Krauss, Karl-Heinz**
**Thomas-Diewald-Strasse 8**
**D-8033 Planegg(DE)**

(54) **Schaltungsanordung zum Umwandeln von Binärinformationen mittels Kontrollbits.**

(57) Die Erfindung bezieht sich auf eine Schaltungsanordnung zum Codieren oder Decodieren mit einer Einrichtung zur Bildung von Kontrollbits unter Verwendung eines linearen Codes. Die Codierung soll sich auf möglichst einfache Weise an eine gewünschte Codierungsart anpassen lassen. Die Erfindung sieht hierzu einen Binärspeicher (1) vor, der je Stelle der Binärinformation ein zugeordnetes Kontrollstellenwort speichert. Dem Speicher (1) ist eine Modulo-2-Addierschaltung (2) zum Aufaddieren von Kontrollstellenwörtern, abhängig von der Binärinformation (k), nachgeschaltet. Eine erfindungsgemäße Schaltungsanordnung ist insbesondere für den Einsatz in Fernwirkeinrichtungen geeignet.

EP 0 003 232 A1

·/· · ·

Croydon Printing Company Ltd.

Fig.1

000323? BEZEICHNUNG GEÄNDERT
siehe Titelseite

SIEMENS AKTIENGESELLSCHAFT    Unser Zeichen
Berlin und München           VPA 77 P 6 8 3 2 BRD

Schaltungsanordnung zum Codieren oder Decodieren von
Binärinformationen

Die Erfindung bezieht sich auf eine Schaltungsanordnung
zum Codieren oder Decodieren mit einer Einrichtung zur
Bildung einer Zahl von Kontrollbits in Abhängigkeit von
mehrere Stellen aufweisenden Binärinformationen unter
Verwendung eines linearen Codes.

Es ist bereits bekannt, bei der Codierung und Decodierung von Binärinformationen Paritätskontrollen vorzunehmen oder rückgekoppelte Schieberegister zur Bildung
eines Sicherungsanhanges zu verwenden. Mit Hilfe von
rückgekoppelten Schieberegistern werden dabei zyklische
Codes realisiert. Der Aufwand steigt dabei mit der Anzahl der Kontrollstellen des Sicherungsanhangs.

Eine Codierung mittels rückgekoppelter Schieberegister
geht beispielsweise aus der Zeitschrift "Elektronik",
1976, Heft 8, Seiten 55 bis 59 hervor. Die Adaptierung
an einen neuen Code oder an Codes mit unterschiedli-

Wd 1 Bri / 22.12.1977

cher Länge ist dabei nicht oder nur mit sehr großem Schaltungsaufwand möglich.

Aufgabe der Erfindung ist es, eine Schaltungsanordnung der vorstehend näher bezeichneten Art derart auszubilden, daß sie sich auf möglichst einfache Weise an eine gewünschte Codierungsart anpassen läßt.

Überlegungen im Rahmen der Erfindung haben ergeben, daß bei der Lösung dieser Aufgabe die Kontrollbits vorteilhaft aus einer Generatormatrix der kanonischen Form abgeleitet werden.

Bei linearen Codes kann man zwischen k binären Nachrichtenstellen $x_1$, $x_2$,...,$x_k$ und m binären Kontrollstellen $x_{k+1}$, $x_{k+2}$,...,$x_{k+m}$ unterscheiden. Wegen der Gültigkeit der Aussagen für die parallele und serielle Darstellung der Codeworte wird in diesem Zusammenhang statt von Schritten von Stellen gesprochen.

Die Kontrollstellen werden aus den Nachrichtenstellen mittels linearer Gleichungen in mod-2-Rechnung bestimmt. Die Bedingungen für diese Gleichungen kann man aus einem sogenannten Prüfschema ermitteln. Das folgende Beispiel beschreibt das Prüfschema eines linearen Codes mit k=4 Nachrichtenstellen und m=3 Kontrollstellen:

| Nachrichtenstellen | | | | Kontrollstellen | | |
|---|---|---|---|---|---|---|
| $x_1$ | $x_2$ | $x_3$ | $x_4$ | $x_5$ | $x_6$ | $x_7$ |
| 1 | 1 | 1 | 0 | 1 | 0 | 0 |
| 1 | 1 | 0 | 1 | 0 | 1 | 0 |
| 1 | 0 | 1 | 1 | 0 | 0 | 1 |

Jede Prüfzeile entspricht einer linearen Gleichung, z.B. die zweite Prüfzeile der Gleichung

$$1 \cdot x_1 + 1 \cdot x_2 + 0 \cdot x_3 + 1 \cdot x_4 + 0 \cdot x_5 + 1 \cdot x_6 + 0 \cdot x_7 = 0 \ (\text{mod } 2)$$

bzw. umgeformt

$$x_6 = x_1 + x_2 + x_4 \qquad (\text{mod } 2)$$

Mit dieser Prüfzeile wird die Kontrollstelle $x_6$ aus den Nachrichtenstellen $x_1$, $x_2$, $x_3$, $x_4$ ermittelt. Die Bedingungen für $x_5$ und $x_7$ kann man sich entsprechend herleiten.

$$x_5 = x_1 + x_2 + x_3 \qquad (\text{mod } 2)$$

$$x_7 = x_1 + x_3 + x_4 \qquad (\text{mod } 2)$$

Für gegebene Werte der Nachrichtenstellen von z.B.
$$(x_1\ x_2\ x_3\ x_4) = (1101)$$
ergeben sich mit diesen drei Gleichungen die Kontrollstellen zu
$$(x_5\ x_6\ x_7) = (010).$$

Das ganze Codewort lautet somit (1101 010). Die Kontrollstellen werden aus den Nachrichtenstellen durch Paritätskontrollen gebildet.

So ergänzt z.B. die Kontrollstelle $x_6$ die Nachrichtenstellen $x_1$, $x_2$ und $x_4$ auf eine gerade Anzahl von Einsen. Zur Bildung dieser Kontrollstelle sind zwei Verknüpfungen erforderlich. Berücksichtigt man den gleichen Aufwand auch für die Kontrollstellen $x_5$ und $x_7$, so muß man schon bei diesem einfachen Beispiel $3 \cdot 2 = 6$ Verknüpfungen für die Codesicherung vorsehen.

Der Aufwand steigt mit steigender Anzahl der Codewortstellen beträchtlich an und findet bei längeren Codes mit hohem Redundanzanteil seine Grenzen.

Andererseits kann man sich aus dem Prüfschema des linea-

0003232

77 P 6 8 3 2 BRD

ren Codes eine allgemeine Beschreibungsform mit k linear unabhängigen Gleichungen, die man auch als Generatorworte bezeichnet, herleiten.

Eine mögliche Wahl für die k Generatorworte sind genau jede k Codeworte, die in den Nachrichtenstellen genau eine "1" enthalten, denn die Summe modulo 2 dieser Worte kann nicht Null sein. In dem zuvor behandelten Beispiel ergeben sich also für die Nachricht (0100) die Kontrollstellen

$$x_5 = 0 + 1 + 0 = 1$$
$$x_6 = 0 + 1 + 0 = 1$$
$$x_7 = 0 + 0 + 0 = 0$$

und damit das Codewort zu (0100 110). Auf diese Weise kann man auch die übrigen Zeilen berechnen und erhält

$$\begin{bmatrix} 1 & 0 & 0 & 0 & 1 & 1 & 1 \\ 0 & 1 & 0 & 0 & 1 & 1 & 0 \\ 0 & 0 & 1 & 0 & 1 & 0 & 1 \\ 0 & 0 & 0 & 1 & 0 & 1 & 1 \end{bmatrix} = (G)$$

als sogenannte Generatormatrix.

Da ein linearer Code die Eigenschaft hat, daß zwei Codeworte addiert wieder ein neues zum Code gehörendes Wort bilden, kann man sich durch Kombination der Zeilen dieser Generatormatrix jede beliebige Nachricht codieren.

So ergibt sich z.B. das Codewort der Nachricht (1101) durch Addition der ersten, zweiten und vierten Zeile der Generatormatrix zu (1101 010). Man nennt die Beschreibung eines Codes durch diese Anordnung der Generatormatrix auch die "kanonische Form".

Die Zeilenvektoren der Kontrollmatrix (H) stellen das beschriebene Plüfschema dar. Für dieses Beispiel ergibt sich die Transponierte $(H)^T$ der Kontrollmatrix (H) zu

$$(H) = \begin{bmatrix} 1 & 1 & 1 & 0 & 1 & 0 & 0 \\ 1 & 1 & 0 & 1 & 0 & 1 & 0 \\ 1 & 0 & 1 & 1 & 0 & 0 & 1 \end{bmatrix} ; \quad (H)^T = \begin{bmatrix} 1 & 1 & 1 \\ 1 & 1 & 0 \\ 1 & 0 & 1 \\ 0 & 1 & 1 \\ 1 & 0 & 0 \\ 0 & 1 & 0 \\ 0 & 0 & 1 \end{bmatrix}$$

Gemäß der Erfindung wird die Schaltungsanordnung derart ausgebildet, daß ein Binärspeicher vorgesehen ist, der je Stelle der Binärinformation ein zugeordnetes Kontrollstellenwort, dessen Stellenzahl gleich der Zahl der Kontrollbits ist, speichert, und daß dem Speicher eine Modulo-2-Addierschaltung zum Aufaddieren von Kontrollstellenwörtern nachgeschaltet ist, und daß die Kontrollstellenwörter in Abhängigkeit von dem Zustand des zugeordneten Bits der Binärinformation einander aufaddierbar sind. Die aufzuaddierenden Kontrollstellenwörter können dabei dadurch aus den gespeicherten Wörtern ausgewählt werden, daß nur die zu Informationsstellen des einen Zustandes gehörenden Kontrollstellenwörter ausgelesen werden. Andererseits kann man alle Kontrollstellenwörter auslesen und den Modulo-2-Addierer durch ein aus der Binärinformation gewonnenes, mit dem Auslesevorgang synchronisiertes Steuersignal so steuern, daß nur die Kontrollstellenwörter aufaddiert werden, deren zugeordnetes Informationsbit einen vorgegebenen Zustand, z.B. den Zustand "1" hat.

Eine derartige Schaltungsanordnung läßt sich in vorteilhafter Weise ohne aufwendige Schaltungsänderungen an die Erfordernisse des jeweiligen Anwendungsfalles anpassen.

In weiterer Ausgestaltung der Erfindung wird die Schaltungsanordnung derart ausgebildet, daß im Nur-Lese-Speicher die Kontrollstellenwörter für mehrere, unterschiedlich viele Stellen aufweisende Binärinformationen speicherbar sind. Weiterhin kann es sich als zweckmäßig erweisen, daß im Speicher für wenigstens eine Binärinformation mindestens zwei Gruppen von Kontrollstellenwörtern speicherbar sind.

Bei einer derartigen Schaltungsanordnung ist es in vorteilhafter Weise ohne weiteres möglich, im Bedarfsfall Codes verschiedener Länge oder sogar untereinander verschiedene Codes mit unterschiedlichen Sicherungseigenschaften zu verwenden.

Mit Hilfe der Schaltungsanordnung läßt sich eine Binärinformation dadurch besonders schnell durch eine bitweise Codierung codieren oder decodieren, daß der Nur-Lese-Speicher synchron mit den seriell auszugebenden Nachrichtenbits auslesbar ist, und daß der Addierschaltung ein Parallel-Serienumsetzer nachgeschaltet ist. Nach dem Aussenden des letzten Nachrichtenbits steht dabei der Sicherungsanhang fest und wird der Binärinformation angefügt.

Auch bei der Decodierung eines Telegramms werden die Kontrollstellen des einlaufenden Telegramms vorteilhaft bitweise ermittelt. Nach Einlauf des letzten Nachrichtenbits stehen die Kontrollschritte dann auf der Empfangsseite fest und können mit den anschließend empfangenen Kontrollbits verglichen werden.

In Weiterbildung der Erfindung ist der Speicher zugleich Bestandteil einer Einrichtung zur Fehlerkorrektur. Dabei wird der Speicher in vorteilhafter Weise zugleich zur Bildung des Fehlersyndroms ausgenutzt.

Die Erfindung wird anhand der in den Figuren dargestellten Ausführungsbeispiele näher erläutert.

Es zeigen:

Fig.1 eine Schaltungsanordnung zum Codieren einer Binärinformation,

Fig.2 Einzelheiten einer in der Schaltungsanordnung
nach Fig.1 enthaltenen Einrichtung zur Informationsverarbeitung und Ablaufsteuerung und

Fig.3 eine Schaltungsanordnung zum Anfügen eines Sicherungsanhanges an ein Impulstelegramm.

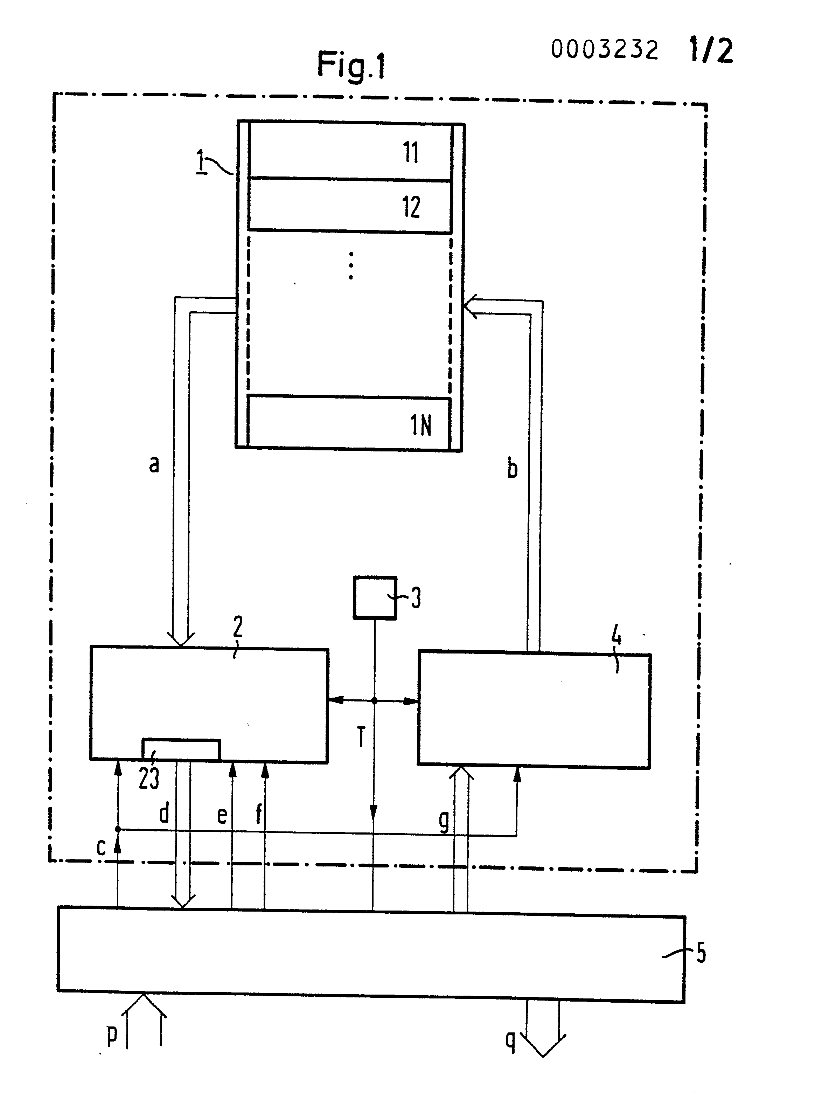

Die in Fig.1 gezeigte Schaltungsanordnung dient dazu,
eine Binärinformation mit einem Sicherungsanhang zu versehen. Die Binärinformation wird der Einrichtung 5, die
zur Ablaufsteuerung und Informationsverarbeitung dient,
am Eingang p als Eingangsinformation zugeführt. Die
Ausgangsinformation, die aus der Eingangsinformation
und dem Sicherungsanhang zusammengesetzt ist, wird am
Ausgang q abgegeben.

Einrichtung 5, Mod-2-Addierer 2 und Adressengeber 4
sind an den Taktgeber 3 angeschlossen.

Der Speicher 1 ist ein Nur-Lese-Speicher, der die Speicherbereiche 11...1N enthält. Jedem dieser Speicherbereiche 11...1N ist eine Adresse zugeordnet und in jedem
Speicherbereich ist die Kontrollmatrix eines bestimmten
Codes in der sogenannten kanonischen Form gespeichert.
Speichert man die Kontrollwörter von mehreren verschiedenen Codes im Speicher, so können in vorteilhafter
Weise Codes gleicher Länge aber mit unterschiedlicher
Hamming-Distanz verwendet werden. Durch Übergehen auf einen neuen Adreßbereich kann man sich sehr leicht den Sicherungsanhang eines neuen Codes berechnen. Das erste Kontrollstellenwort der Matrize eines jeden Codes steht unter der als Anfangsadresse dienenden Adresse des Speicherbereiches.

Der Adressengeber 4 wird zunächst von der Einrichtung 5 aus über die Rücksetzleitung c zurückgesetzt, daran anschließend über den Adressenbus g mit der Adresse der gewünschten Kontrollmatrix beaufschlagt und dann durch den Takt T weitergeschaltet.

Auf diese Weise werden die Daten der Kontrollstellen bzw. die Kontrollstellenwörter in zeitlicher Folge aus dem Speicher A ausgelesen und über den Datenbus a an den Modulo-2-Addierer 2 abgegeben.

Der Addierer 2 wird zunächst ebenfalls über die Rücksetzleitung c zurückgesetzt und dann mit den Kontrollstellenwörtern beaufschlagt. Über die Steuerleitung e erhält er gleichzeitig mit jedem Kontrollstellenwort eine Information darüber, ob dieses Kontrollstellenwort aufzuaddieren ist oder nicht. Hierbei enthält der Speicher 1 k Worte mit m Schritten. Jedes Wort ist einem Nachrichtenschritt zugeordnet und es wird abgerufen, wenn der Nachrichtenschritt den Kennzustand "1" besitzt.

Das Additionsergebnis wird im Ergebnisregister 23 gespeichert und gelangt von dort über den Datenbus b an die Einrichtung 5, sobald diese den Addierer 2 durch ein an die Steuerleitung f abgegebenes Signal "Übernahme Sicherungsanhang" hierzu auffordert.

Die Codierung und Decodierung geschieht folgendermaßen:

Um die Nachricht zu codieren, definiert man die Kontrollbits der Generatormatrix der kanonischen Form im ROM
bzw. Nur-Lese-Speicher 1. Durch Aufaddieren modulo 2
der Kontrollbits ergibt sich der Sicherungsanhang.

Bei der gespeicherten Matrix ist jeweils die erste Zeile dem ersten Nachrichtenbit, die zweite Zeile dem zweiten Nachrichtenbit usw. zugeordnet. Die letzte Zeile der
Matrix entspricht dem letzten Nachrichtenbit. Für jede
"1" eines Nachrichtenbits wird die entsprechende Zeile
der Matrix aufaddiert modulo 2. Nach Auswertung des
letzten Nachrichtenbits steht der Sicherungsanhang fest.

Für das eingangs behandelte Beispiel ergibt sich folgender Codierungsablauf:

| Speicher-adresse | Speicher-inhalt | | | | | | | |
|---|---|---|---|---|---|---|---|---|
| | | | $x_1$ | $x_2$ | $x_3$ | $x_4$ | $x_5$ | $x_6$ $x_7$ |
| ADR | 1 1 1 | | | | | | | |
| ADR +1 | 1 1 0 | | | | | | | |
| ADR +2 | 1 0 1 | Nachricht | 1 | 1 | 0 | 1 | ? | ? ? |
| ADR +3 | 0 1 1 | | | | | | | |

Da die Stelle $x_1$ der Nachricht eine "1" aufweist, wird
der Speicherinhalt der Adresse ADR gelesen. Da auch $x_2$
den Wert "1" enthält, werden die Speicherinhalte von
ADR und ADR+1 im Addierer 2 addiert modulo 2. Die Stelle $x_3$ enthält "0" und $x_4$ enthält den Wert "1", folglich
addiert der Addierer 2 noch den Speicherinhalt der Adresse ADR+3 zu der errechneten Summe dazu. Das Endergebnis ergibt sich zu 010 und wird als Sicherungsanhang
den Informationsbits angefügt.

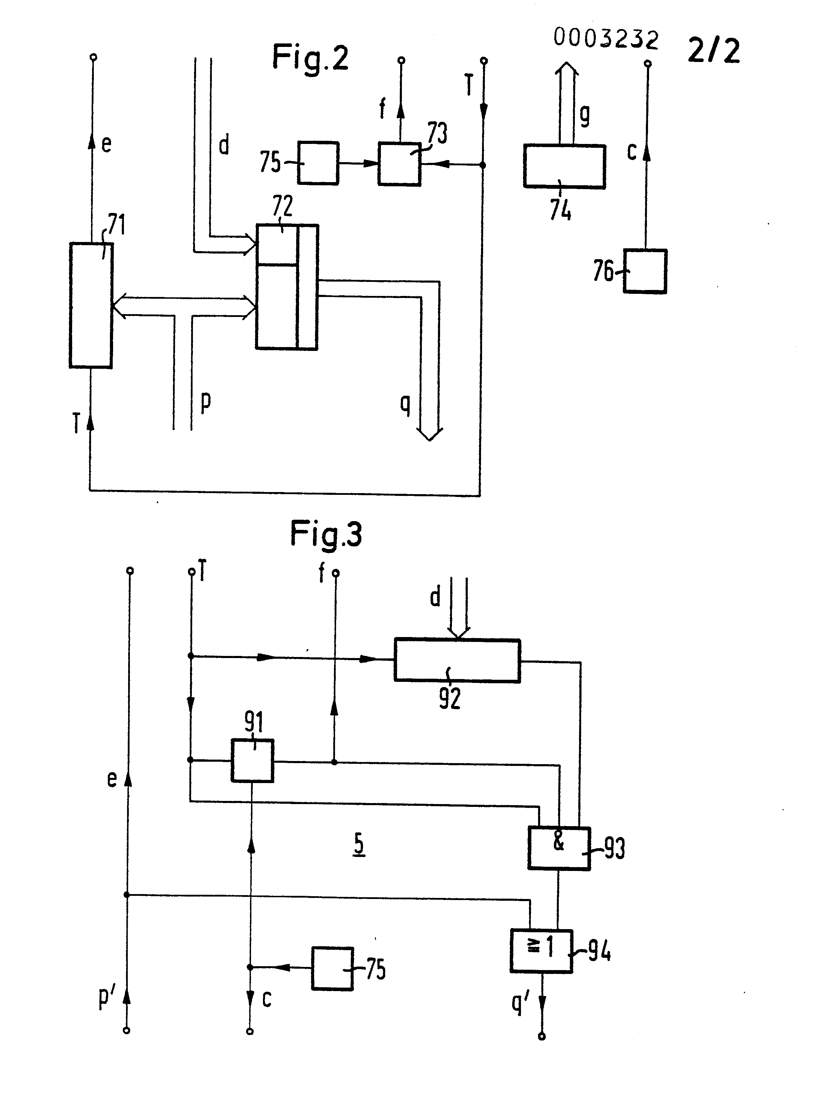

Das Beispiel macht deutlich, daß man bei einem seriell
auszugebenden Telegramm die Kontrollbits vorteilhaft synchron mit jedem ausgegebenen Nachrichtenbit ermitteln kann. Durch dieses Verfahren ist ein sehr schnelles Verarbeiten der Nachrichtenstellen möglich. Eine Schaltungsanordnung dieser Art ist in Fig.3 gezeigt.

Weitere Einzelheiten der Einrichtung 5 gehen aus Fig.2 hervor. Die Eingangsinformation wird den Registern 71 und 72 über den Eingang p als Parallelinformation zugeführt. Daran anschließend wird die im Register 71 gespeicherte Information mit Hilfe des Taktes T seriell an die Steuerleitung e abgegeben.

Das Register 72 enthält zusätzlich zu dem an den Eingang p angeschlossenen Teil weitere Stufen, die am Datenbus d liegen und zur Speicherung des Sicherungsanhanges vorgesehen sind. Eingangsinformation und Sicherungsanhang werden gemeinsam über den Datenbus q ausgegeben.

Ferner läßt sich mit Hilfe des Adressengebers 74 die gewünschte Speicherbereich-Adresse an den Adressenbus g abgeben. Der Adressengeber 74 kann z.B. eine Schalteranordnung sein, mit deren Hilfe der gewünschte Speicherbereich eingestellt wird.

Der Steuerteil 73 gibt das Signal "Übernahme Sicherungsanhang" an die Steuerleitung f ab. Der Steuerteil 73 ist z.B. ein mit dem Takt T gesteuerter Zähler, der mittels des Rücksetzsignalgebers 75 rücksetzbar ist und bis zu einer der Zahl der Informationbits entsprechenden Zahl von Taktimpulsen zählt. Insbesondere läßt sich die zu zählende Zahl auf die jeweilige Zahl der Informationsbits einstellen.

In vorteilhafter Weise kann der Binärspeicher zugleich Bestandteil einer in der Figur nicht dargestellten Einrichtung zur Fehlerkorrektur sein.

Die Korrektur eines einzelnen Fehlers bzw. ein einzelnes Fehlerwort mit dem Hamming-Gewicht 1 ist mit geringem Aufwand möglich. Das sogenannte Syndrom bzw. der Korrektor s ist ein (n-k)-stelliger Vektor, der sich aus einem Empfangswort (w) zu

$$(s) = (w) \, (H)^T$$

ergibt. Ist (w) ein ungestörtes Codewort, muß (s) = 0 sein. Eine Korrektur ist also nicht erforderlich. Ist (s) $\neq$ 0, so korrigiert man genau diejenige Stelle, an der dieser Zeilenvektor in $(H)^T$ steht. $(H)^T$ enthält dabei die Kontrollstellen der Generatormatrix der kanonischen Form. Bei dem eingangs genannten Beispiel wird das Codewort (u) = (1100 001) gesendet und das Codewort (w) = (1101 001) empfangen. Es liegt also die Verfälschung einer einzigen Bitstelle vor. Das Syndrom ergibt sich zu

$$(s) = (1101 \; 001) \begin{bmatrix} 1 & 1 & 1 \\ 1 & 1 & 0 \\ 1 & 0 & 1 \\ 0 & 1 & 1 \\ 1 & 0 & 0 \\ 0 & 1 & 0 \\ 0 & 0 & 1 \end{bmatrix} = (011) \neq 0$$

Das Syndrom (011) entspricht der Störung der vierten Codewortstelle.

Zweckmäßigerweise empfängt die Empfangsstation die im Sender gebildeten Kontrollstellen und ermittelt gleichzeitig mit Hilfe der gespeicherten Kontrollstellenbytes die Kontrollstellen der einlaufenden Nachricht. Stimmen

0003232

beide Werte nicht überein, werden sie in einem Addierer addiert modulo 2 und ergeben das Syndrom (s). In anderen Worten:

$$(s) = (k_u) + (k_w)$$

Für das angegebene Beispiel ergibt sich

$$(k_u) = 0 \quad 0 \quad 1$$
$$(k_w) = \underline{0 \quad 1 \quad 0}$$
$$(s) = 0 \quad 1 \quad 1 \qquad \text{modulo 2}$$

Fig.3 zeigt Einzelheiten der Einrichtung 5 für den Fall, daß die Eingangsinformation und die Ausgangsinformation Serieninformationen sind.

Die Eingangsinformation gelangt über die Eingangsleitung p' an die Steuerleitung e und einen Eingang des ODER-Gliedes 94, dessen anderer Eingang an das Dreifach-UND-Glied 93 angeschlossen ist.

Über den Datenbus d gelangt der Sicherungsanhang in das Schieberegister 92. Mit Hilfe des Taktes T wird der Sicherungsanhang aus dem Schieberegister 92 geschoben und seriell an einen Eingang des UND-Gliedes 93 geführt. Von den beiden weiteren Eingängen des UND-Gliedes 93 wird der eine mit dem Takt T und der andere mit dem Ausgangssignal des durch den Takt T gesteuerten Zählers 91 beaufschlagt.

Der Ausgang des Zählers 91 ist ferner an die Steuerleitung f geführt.

Das Impulstelegramm gelangt über die Leitung p' und das nachgeschaltete ODER-Glied 94 an die Ausgangsleitung q'. Gleichzeitig werden die Informationsbits des Impulstele-

0003232
77 P 6 8 3 2 BRD

gramms über die Leitung e an den nicht dargestellten Modulo-2-Addierer geführt.

Der Impulszähler 91 wird zunächst mit Hilfe des Rücksetzsignalgebers 75 zurückgestellt. Daran anschließend zählt der Zähler 91 bis zu einer Zahl Taktimpulse T, die gleich der Zahl der Informationsbits des Impulstelegramms ist. Bei Erreichen dieser Zahl gibt der Zähler am Ausgang ein Kriterium ab, das über die Leitung f als Kriterium "Übernahme Sicherungsanhang" an den Modulo-2-Addierer gelangt. Außerdem ist das Ausgangssignal des Zählers 91 an einen Eingang des Dreifach-UND-Gliedes 93 geführt und bewirkt, daß der Sicherungsanhang über das UND-Glied 93 zum ODER-Glied 94 gelangen kann.

Auf diese Weise wird erreicht, daß an die Ausgangsleitung q' ein Impulstelegramm abgegeben wird, das aus den Informationsbits des eingegebenen Telegramms und dem daran anschließenden Sicherungsanhang besteht.

Zweckmäßigerweise kann als Einrichtung zur Ablaufsteuerung jeweils ein Mikroprozessor Verwendung finden.

In verschiedenen bekannten Fernwirksystemen werden die Informationen zwischen den Stationen durch Telegramme ausgetauscht, die k Nachrichten und m Kontrollschritte enthalten. Mit Hilfe der Kontrollschritte kann die empfangende Station prüfen, ob die Nachricht ungestört übertragen worden ist. Die Schaltungsanordnung läßt sich vorteilhaft dazu verwenden, derartige Fernwirktelegramme zu sichern. Der Aufwand hierfür steigt mit der Anforderung an die Sicherheit einer zu übertragenden Nachricht.

Von besonderem Vorteil ist, daß sich die Codeworte eines gesicherten Codes nach wählbarer Vorschrift her-

0003232

stellen lassen. Während das Fernwirkgerät die Nachrichtenschritte nacheinander aussendet, werden die aus dem Speicher 1 abgerufenen Worte im Register 23 des Addierers 2 aufaddiert. Ist der letzte Nachrichtenschritt ausgesendet, stehen die zum Telegramm gehörigen m Kontrollschritte im Register 23 schon zur Aussendung bereit.

5 Patentansprüche
3 Figuren

Patentansprüche

1. Schaltungsanordnung zum Codieren oder Decodieren mit einer Einrichtung zur Bildung einer Zahl von Kontrollbits in Abhängigkeit von mehrere Stellen aufweisenden Binärinformationen unter Verwendung eines linearen Codes, d a d u r c h   g e k e n n z e i c h n e t , daß ein Binärspeicher (1) vorgesehen ist, der je Stelle der Binärinformation ein zugeordnetes Kontrollstellenwort, dessen Stellenzahl gleich der Zahl der Kontrollbits ist, speichert, und daß dem Speicher (1) eine Modulo-2-Addierschaltung (2) zum Aufaddieren von Kontrollstellenwörtern nachgeschaltet ist, und daß die Kontrollstellenwörter in Abhängigkeit von dem Zustand des zugeordneten Bits der Binärinformation (k) einander aufaddierbar sind.

2. Schaltungsanordnung nach Anspruch 1, d a d u r c h   g e k e n n z e i c h n e t ,  daß im Nur-Lese-Speicher (1) die Kontrollstellenwörter für mehrere, unterschiedlich viele Stellen aufweisende Binärinformationen (k) speicherbar sind.

3. Schaltungsanordnung nach Anspruch 1 oder 2, d a - d u r c h   g e k e n n z e i c h n e t ,  daß im Speicher (1) für wenigstens eine Binärinformation (k) mindestens zwei Gruppen von Kontrollstellenwörtern speicherbar sind.

4. Schaltungsanordnung nach einem der Ansprüche 1 bis 3, d a d u r c h   g e k e n n z e i c h n e t ,  daß der Nur-Lese-Speicher (1) synchron mit den seriell auszugebenden Nachrichtenbits auslesbar ist, und daß der Addierschaltung (2) ein Parallel-Serienumsetzer (92) nachgeschaltet ist (Fig.3).

0003232
77 P 6 8 3 2 BRD

5. Schaltungsanordnung nach einem der vorhergehenden Ansprüche, d a d u r c h  g e k e n n z e i c h n e t, daß der Nur-Lese-Speicher zugleich Bestandteil einer Einrichtung zur Fehlerkorrektur ist.

Fig.1

Fig.2

Fig.3

0003232

Nummer der Anmeldung

EP 78 10 1773

**Europäisches Patentamt**

**EUROPÄISCHER RECHERCHENBERICHT**

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | <u>DE - B - 1 287 605</u> (TELEFUNKEN) <br> * Spalte 1, Zeilen 14-21; Spalte 2, Zeile 47 bis Spalte 4, Zeile 6; Figuren 2,3 * <br> --- | 1,2,4, 5 |
| | <u>DE - A - 2 531 425</u> (SCHRACK) <br> * Seite 2, Absätze 3-5; Seite 6, Absätze 2,3 * <br> ---- | 2,3 |

**KLASSIFIKATION DER ANMELDUNG (Int.Cl.²)**

G 06 F 11/10
H 04 L 1/10

**RECHERCHIERTE SACHGEBIETE (Int. Cl.²)**

G 06 F 11/10
H 04 L 1/10

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 04-04-1979 | WEBER |

EPA form 1503.1 06.78